# EUROPEAN PATENT SPECIFICATION

(11) **EP 0 600 672 B1**
(45) Date of publication and mention of the grant of the patent: **24.02.1999**
(21) Application number: 93309436.9
(22) Date of filing: 25.11.1993
(51) Int. Cl.: H01L 21/00, B21D 28/00, G05B 19/12, B26D 5/00

(54) **Machine for trimming and forming lead frames**
Anpassungs- und Formungsmaschine für Leiterrahmen
Machine pour ajuster et former des cadres conducteurs

(30) Priority: 28.11.1992 JP 341272/92
(43) Date of publication of application: 08.06.1994
(73) Proprietor: APIC YAMADA CORPORATION, Hanishina-gun, Nagano 389-08 (JP)
(72) Inventor: Ando, Shin, c/o Apic Yamada Corporation, Hanishina-Gun, Nagano 389-08 (JP); Todoroki, Yoshinao, c/o Apic Yamada Corporation., Hanishina-Gun, Nagano 389-08 (JP); Shizuya, Takaaki, c/o Apic Yamada Corporation., Hanishina-Gun, Nagano 389-08 (JP); Kanayama,Fujio c/o Sony Corporation, Shinagawa-ku, Tokyo 141 (JP); Hokari, Sumio , c/o Sony Corporation, Shinagawa-ku, Tokyo 141 (JP); Shibue, Hitoshi c/o Sony Corporation, Shinagawa-ku, Tokyo 141 (JP)
(74) Representative: Sanderson, Michael John

(56) References cited:
- DE-A- 3 406 325
- DE-A- 3 707 412
- GB-A- 2 191 026
- US-A- 4 644 633
- US-A- 5 054 188
- US-A- 5 105 857

## Description

The present invention relates to a trimming and forming machine (hereinafter referred to as "T/F machine").

Conventionally, a T/F machine for trimming and forming, for example, lead frames of semiconductor devices has a conveying mechanism for conveying lead frames from one machining stage to another. And a die-punch set for trimming and forming lead frames are set in the T/F machine. Die-punch sets are selected and exchanged according to a type of lead frames to be machined.

In the conventional T/F machine, the die-punch set must be exchanged when a type of lead frame is changed. Moreover, width between conveyor rails, which constitute the conveying mechanism, a lead frame feeding length for each trimming and forming step, etc. should be changed. These days, T/F machines, which are capable of automatically setting the rail width, the lead frame feeding length, etc., are used. Data for automatic setting are inputted to a control unit including a microprocessor by an operator with a ten-key board with reference to reference materials, e.g., a data sheet. When a type of lead frame is changed, for example, new data of the rail width, the lead frame feeding length for each step, etc. are inputted to the control unit, then the control unit automatically changes the the rail width, the lead frame feeding length for each step, etc. with reference the data, so that the new type lead frames can be trimmed and formed by the T/F machine.

However, the conventional T/F machines have following disadvantages.

When a type of lead frame is changed, for example, the die-punch set must be exchanged, so that new data of the rail width, the lead frame feeding length, etc. for the new type must be inputted to the control unit by the operator with the ten-key board with reference to the reference materials. But it is troublesome for the operator to manually input the data with reference thereto, and working efficiency cannot be raised.

Furthermore, error data are sometimes inputted because of manually inputting.

US-A-5054188 discloses a trim, form and cut machine for trimming plastic flash from an IC chip and cutting the connections between chip leads. The machine utilises interchangeable modules and interchangeable punches and is provided with means for removing the material trimmed from the IC chips and leads.

An object of the present invention is to provide a T/F machine, which is capable of automatically inputting data to means for controlling the T/F machine without manual operations, and a die-punch set, which is capable of being set in the T/F machine.

According to the present invention there is provided a machine for trimming and forming lead frames, the machine comprising an exchangeable die-punch set adapted to a specific lead frame, characterised in that the die-punch set includes means for storing specific data for control and maintenance, and further characterised in that the machine comprises means for reading the specific data from the storing means, and means for controlling the timing and forming operation and the maintenance of the machine on the basis of a control programme and the specific data as read by the reading means.

Note that, corrected specific data may be written in the storing mean. And the storing means may store not only the specific data but also control programs of the control means.

In the present invention, the specific data for control and maintenance are stored in the storing means of the die-punch set. While the T/F machine is controlled on the basis of the specific data, which are stored in the storing means of the die-punch set. Thus, the specific data are automatically inputted to the control means of the T/F machine when the die-punch set is exchanged. An operator need not input the data with reference to reference materials, so that operators' load are reduced, and working efficiency can be raised. Furthermore, no error data are inputted because of automatically inputting.

If the specific data are capable of being written in the storing means of the die-punch set, the T/F machine can be controlled on the basis of the newest data.

If the T/F machine has no control programs and they are stored in the storing means of the die-punch set together with the specific data, changing the control programs is not required. Thus, the T/F machine will be used for a wide use.

Embodiments of the present invention will now be described by way of examples and with reference to the accompanying drawings, in which:
Fig. 1 is a partial plan view of a T/F machine of a first embodiment;
Fig. 2 is a partial front view thereof;
Fig. 3 is a block diagram of a control system thereof;
Fig. 4 is a flowchart showing action of an MPU of the first embodiment;
Fig. 5 is a flowchart showing action of the MPU of a second embodiment; and
Fig. 6 is a flowchart showing action of the MPU of a third embodiment.

Preferred embodiments of the present invention will now be described in detail with reference to the accompanying drawings. Note that, a T/F machine for trimming and forming lead frames of semiconductor devices will be explained as an example of T/F machines in the following embodiments.

### (First Embodiment)

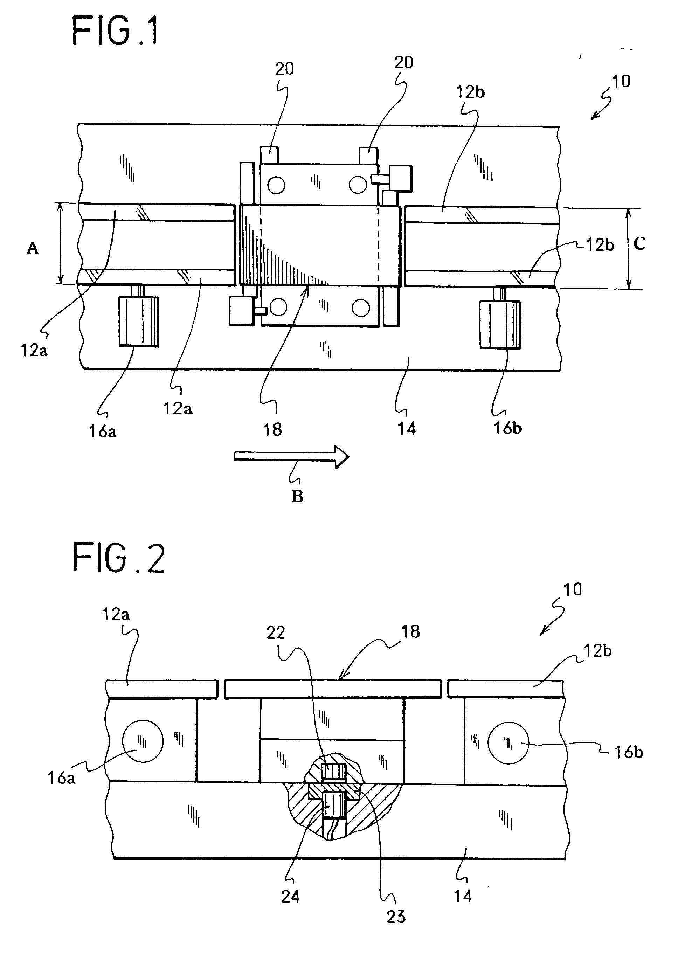

A first embodiment will be explained with reference to Figs. 1-4.

A T/F machine 10 has a pair of conveyor rails 12a and 12b. The conveyor rails 12a and 12b are provided on a base 14, which constitutes a part of a machine proper of the T/F machine 10. Leadframes (not shown) to be trimmed and formed are conveyed on the rails 12a in a direction of an arrow B. Lead frames which have been trimmed and formed are conveyed on the rails 12b in the direction of the arrow B. The lead frames are moved on the rails 12a and 12b by a mechanism (not shown). Note that, there are provided means for measuring the rail width A and C, and means for returning the rails 12a and 12b to their initial positions.

Rail adjusting motors 16a and 16b are, for example, pulse motors. The rail width A and C of the rails 12a and 12b can be adjusted by the motors 16a and 16b. In the present embodiment, the rails 12a are screwed with a screw rod (not shown), which is rotated by the motor 16a. By rotating the screw rod, the rails 12a are moved close to and away from each other, so that the rail width A can be adjusted. On the other hand, the rails 12b are screwed with another screw rod (not shown), which is rotated by the motor 16b. By rotating the screw rod, the rails 12b are moved close to and away from each other, so that the rail width C can be adjusted. When a type of the lead frames is changed, the rail width A and C must be changed so the rail width A and C will be adjusted to proper sizes. To adjust the rail width A and C, the rails 12a and 12b are once moved to the initial positions, then the rails 12a and 12b are moved by driving the motors 16a and 16b.

A die 18 is set in the base 14. Note that, a punch which corresponds to the die 18 is not shown in the drawings. The punch is vertically moved by a driving mechanism (not shown) and capable of trimming and forming lead frames together with the die 18 as a die-punch set. A type of the die 18 is selected according to the type of the lead frames to be trimmed and formed. Thus, the die 18, which corresponds to a size, etc. of the lead frames, is set in the base 14. The rail width A and C also correspond to the die 18. The lead frames to be trimmed and formed are fed to the die 18 via the rails 12a; the lead frames trimmed and formed are conveyed out from the die 18 to the next step.

Sensors 20 are provided in the base 14. The sensors 20 detect if the die 18 is correctly set in the base 14 or not. The sensors 20 are arranged as shown in Fig. 1 so as to precisely detect. When the die 18 is set at a proper position, the sensors 20 output signals. A photo sensor, an approach sensor, a limit switch, etc. may be used as the sensors 20.

A memory unit 22, which is an example of means for storing specific data, is a sort of magnetic memory units. Data are stored in the memory unit 22, and the data can be renewed. In the present embodiment, identification data of the die 18 (or the die-punch set), which is an example of the specific data, is previously stored in the memory unit 22. The identification data are, for example, a specific numeric code assigned to the type of the die 18. And corrected data can be rewritten in the memory unit 22. In the present embodiment, the memory unit 22 is provided in a lower part of the die 18. Note that, secondary memory units, e.g., IC cards, static RAMs, flush memories, may be used as the storing means instead of the magnetic memory unit 22. As shown in Fig. 2, the memory unit 22 is provided in the die 18 but it may be provided to the punch or the both.

A magnetic head 24, which is an example of means for reading the identification data from and writing the newly corrected data to the memory unit 22, is capable of magnetically connecting to the memory unit 22 via a non-magnetizable member 23. The head 24 is provided at a predetermined position in the base 14. When the die 18 is correctly set in the base 14, the head 24 corresponds to the memory unit 22. In the present embodiment, the head 24 is capable of magnetically connected to the memory unit 22 but other means, e.g., a detachable connector, may be used. For example, if a static RAM is used as the storing means and the specific data including the identification data, control data and maintenance data are read and renewed through the detachable connector, a large quantity of the data can be treated.

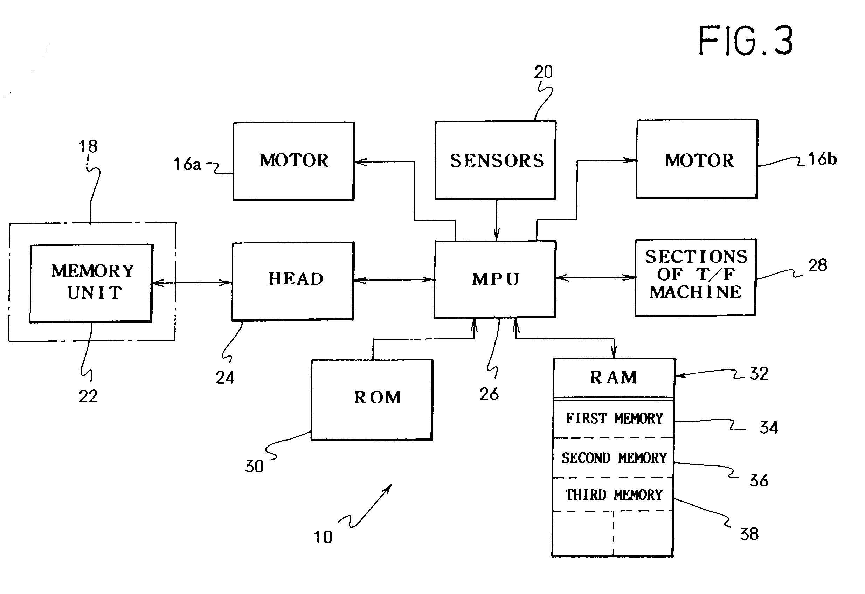

Next, a control system of the T/F machine 10 will be explained with reference to a block diagram of Fig. 3.

A microprocessor (MPU) 26, which has function of means for controlling the movement of the T/F machine 10, is capable of reading the identification data from the memory unit 22 and writing the corrected identification data therein by the head 24. The MPU 26 is also capable of controlling the motors 16a and 16b, various sections 28, the mechanism for changing the rail width A and C, an input unit and an output unit on the basis of the identification data read by the head 24, other specific data for control and maintenance, signals from the sensors 20, signals indicating the rail widthA and C, etc..

A ROM 30 is storing an operating system of the MPU 26, the control programs of the T/F machine 10, the specific data for control and maintenance. The specific data stored in the ROM 30 include identification codes, the rail width A and C, lead frame feeding strokes for each trimming and forming step, sizes (width, length and height) of lead frame supplying magazines, which supply the lead frames to be trimmed and formed to the die 18, number and sizes (width, length, height and number of piling) of lead frame collecting magazines, which accommodate the lead frames trimmed and formed in the die 18, locations and sizes (width, length, thickness and number of piling) of lead frame collecting trays, which accommodate the lead frames trimmed and formed in the die 18, etc., and they are stored as data tables. Note that, secondary memories, such as IC cards, may be used instead of the ROM 30.

A memory area of a RAM 32 is divided into a first memory 34, a second memory 36, a third memory 38, ······. The identification data of the present die 18, which are stored in the memory unit 22 and read by the head 24, are stored in the first memory 34. The specific data stored in the table data of the ROM 30 and selected by the MPU 26 are stored in the second memory 36. The newest data to be written in the memory unit 22 will be stored in the third memory 38. Besides them, the present rail width A and C of the rails 12a and 12b, data for driving the rails 12a and 12b, height of an elevator of the lead frame supplying magazines, and information processed by the MPU 26 are also temporally stored in the RAM 32. In case of judging the types of the lead frames by a camera, picture data, which are processed by the MPU 26, will be stored in the RAM 32. Note that, secondary memories, e.g., IC cards, may be used instead of the RAM 32.

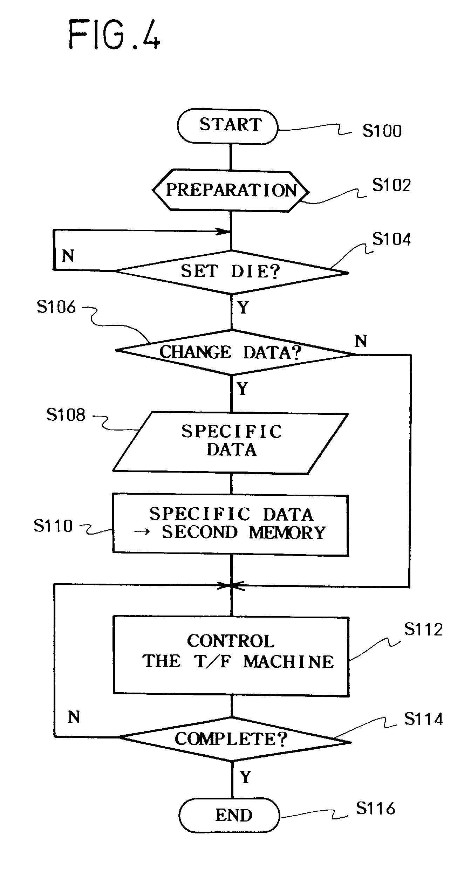

Successively, the movement of the T/F machine 10 will be explained with reference to a flowchart of Fig. 4.

Firstly, an operator sets the die 18 onto the base 14, then he turns on the T/F machine 10 (STEP 100).

When the T/F machine 10 is turned on, the MPU 26 clears the RAM 32, and executes clamping action so as to correctly set the die 18 at a predetermined position (STEP 102). During the clamping action, the punch is also set at a predetermined position above the die 18.

After the STEP 102, the MPU 26 checks if the the die 18 is set at the predetermined position on the base 14 or not by the sensors 20 (STEP 104).

At the STEP 104, if the die 18 is correctly set, the MPU 26 reads the identification data of the die 18 from the memory unit 22, and checks if the data in the first memory 34 of the RAM 32 is equal to the data read or not (STEP 106). In case of starting the T/F machine 10, the first memory 34 of the RAM 32 is cleared at the STEP 102, so the MPU 26 knows that the data in the first memory 34 is changed. Then the MPU 26 stores the identification data in the first memory 34, and retrieves the specific data, which correspond to the identification data, in the ROM 30 (STEP 108). The specific data retrieved are stored in the second memory 36 of the RAM 32 (STEP 110).

In case that the die 18 is changed but the identification data is not changed at the STEP 106, the MPU 26 jumps to STEP 112.

Upon storing the specific data in the second memory 36, the MPU 26 controls the sections 28 for proper trimming and forming actions with reference to the specific data, etc. (STEP 112). Namely, the MPU 26 controls the motors 16a and 16b for adjusting the rail width A and C of the rails 12a and 12b. And the MPU 26 forwards the lead frames to a predetermined length in the direction of the arrow B (see Fig. 1) step by step with each trimming and forming action.

When one sequence of the trimming and forming actions are completed, the MPU 26 checks if no lead frames are left in the lead frame supplying magazines or not (STEP 114). In case of no lead frames, the MPU 26 stops the sections 28 of the T/F machine 10 (STEP 116) to complete the control. On the other hand, at the STEP 114, if there are the lead frames in the lead frame supplying magazines, the MPU 26 returns to the STEP 112 for the next sequence of actions.

In the present embodiment, data except the identification data can be written in the memory unit 22 to store. If the latest shot number of the die-punch set, which is added to previous data, is stored in the memory unit 22 as one of the latest maintenance data, the MPU 26 can read the latest maintenance data at the beginning of every sequence, so that the degree of exhaustion of the die-punch set can be immediately known. When the shot number is greater than a predetermined number indicating a span of life of the die-punch set, the operator can know timing of exchanging the die 18 and/or the punch.

The data in the memory unit 22 in the die 18 can be corrected and renewed, and the head 24 in the base 14 is capable of reading data from and writing data in the memory unit 22. But a read only memory, which stores the identification data, may be used instead of the memory unit 22. In this case, too, specific data can be automatically inputted to the MPU 26 when the die 18 is exchanged.

### (Second Embodiment)

A second embodiment will be explained with reference to Figs. 1- 3 and 5. The second embodiment is a modification of the first embodiment, so the T/F machine 10 and the die-punch set of the first embodiment (see Figs. 1-3) can be used, and explanation will be omitted.

In the first embodiment, the memory unit 22 stores the identification data of the die 18 or the die-punch set. In the second embodiment, means having large memory area, such as a static RAM, is used as the memory unit 22. With large memory are, the memory unit 22 stores the identification data and all or a part of control and/or maintenance data of the die 18 (or the die-punch set).

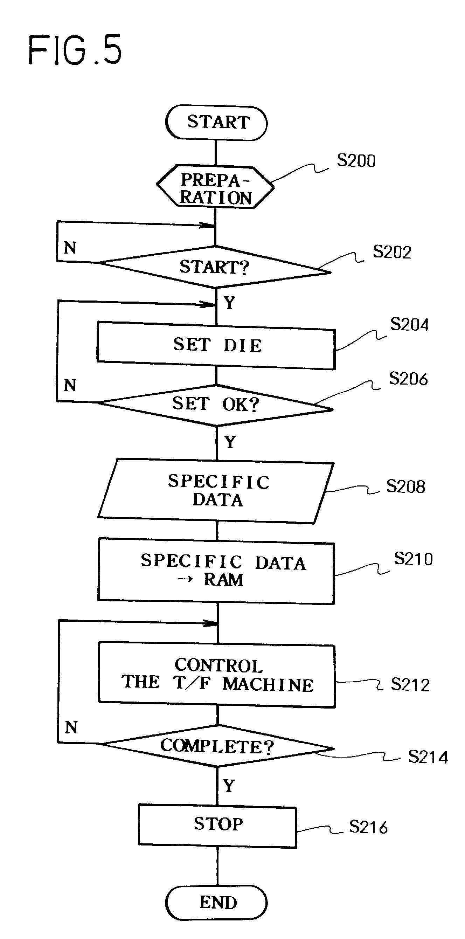

The action of the MPU 26 will be explained with reference to Fig. 5.

Firstly, the T/F machine 10 is turned on, the MPU 26 clears the RAM 32, etc. for preparation (STEP 200).

When the operator inputs command of starting (STEP 202), the MPU 26 executes clamping action so as to correctly set the die 18 at a predetermined position (STEP 204). During the clamping action, the punch is also set at a predetermined position above the die 18.

After the STEP 204, the MPU 26 checks if the the die 18 is set at the predetermined position on the base 14 or not by the sensors 20 (STEP 206). At that time, the MPU 26 also checks if the die 18 matches with the T/F machine 10 or not on the basis of stored data.

At the STEP 206, if the die 18 is correctly set, the MPU 26 reads the specific data, which are the identification data of the die 18 and the data for control and maintenance, from the memory unit 22 by the head 24 (STEP 208), and stores them in the RAM 32 (STEP 210).

The MPU 26 controls the sections 28 for proper trimming and forming actions with reference to the specific data, etc. (STEP 212). Namely, the MPU 26 controls the motors 16a and 16b for adjusting the rail width A and C of the rails 12a and 12b with reference to the control data of the specific data. And the MPU 26 forwards the lead frames to a predetermined length in the direction of the arrow B (see Fig. 1) step by step with each trimming and forming action.

When one sequence of the trimming and forming actions are completed, the MPU 26 checks if no lead frames are left in the lead frame supplying magazines or not (STEP 214). In case of no lead frames, the MPU 26 stops the sections 28 of the T/F machine 10 (STEP 216) to complete the control. On the other hand, at the STEP 214, if there are the lead frames in the lead frame supplying magazines, the MPU 26 returns to the STEP 212 for the next sequence of actions.

In the present embodiment, too, the corrected or renewed specific data can be written in the memory unit 22 to store. For example, the latest shot number of the die-punch set, which is added to previous data, can be stored in the memory unit 22 as the latest maintenance data. Thus, the MPU 26 can read the latest maintenance data at the beginning of every sequence, so that the degree of exhaustion of the die-punch set can be known. If the shot number is greater than a predetermined number indicating a span of life of the die-punch set, the operator can know timing of exchanging the die 18 and/or the punch.

If the latest specific data are written in the memory unit 22 by the head 24 when the die 18 (and the punch) is removed from the base 14, the T/F machine 10 can be controlled and managed on the basis of the latest specific data. And if details of trouble, which have occurred in the die 18 (or the die-punch set), are written in the memory unit 22 by the input unit, history of the die 18 can be known, so that proper maintenance can be executed.

### (Third Embodiment)

A third embodiment will be explained with reference to Figs. 1- 3 and 6. The third embodiment is a modification of the first and the second embodiments, so the T/F machine 10 and the die-punch set of the first embodiment (see Figs. 1-3) can be used, and explanation will be omitted.

In the first embodiment, the memory unit 22 stores the identification data of the die 18 or the die-punch set; in the second embodiment, the memory unit 22 stores the identification data and all or a part of control and maintenance data of the die 18. In the present embodiment, the memory unit 22, e.g., a static RAM, also has large memory area so as to store all the specific data and a control program for the die 18 (or the die-punch set).

In the third embodiment, the specific data, which are the identification data of the die 18, and the data for control and maintenance for the T/F machine 10 with the die 18, and the control program(s) of the T/F machine 10 with the die 18 are previously stored in the memory unit 22, and they can be corrected or renewed.

The ROM 30 previously stores the operating system of the MPU 26 and a basic program(s) for reading the specific data and the control program from the memory unit 22.

The RAM 32 will store the specific data and the control program read from the memory unit 22.

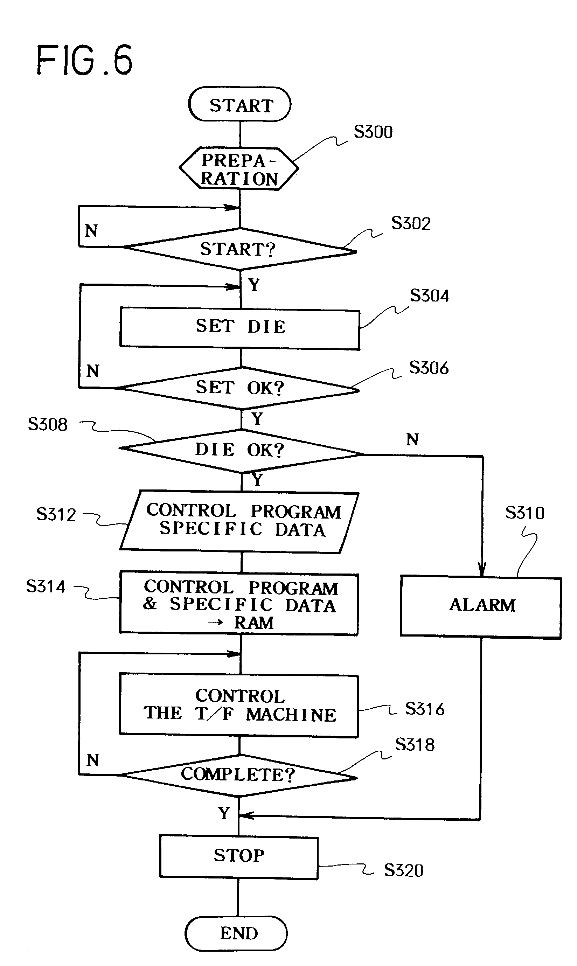

Successively, the action of the MPU 26 will be explained with reference to a flowchart of Fig. 6.

Firstly, the operator set the die 18 onto the base 14 and turns on the T/F machine 10.

Upon turning on the T/F machine 10, the MPU 26 clears the RAM 32, etc. for preparation (STEP 300).

When the operator inputs command of starting (STEP 302), the MPU 26 executes clamping action so as to correctly set the die 18 at a predetermined position (STEP 304). During the clamping action, the punch is also set at a predetermined position above the die 18.

After the STEP 304, the MPU 26 checks if the the die 18 is set at the predetermined position on the base 14 or not by the sensors 20 (STEP 306).

At the STEP 306, if the die 18 is correctly set, the MPU 26 checks if the die 18 (or the die-punch set) matches with the T/F machine 10 or not (STEP 308). At the STEP 308, if the die 18 is not for the T/F machine 10, automatic operation cannot be executed. In this case, the MPU 26 informs the operator by the output unit, e.g., a display unit, an alarm unit (STEP 310), and stops the T/F machine 10 (STEP 320).

On the other hand, at the STEP 308, if the die 18 matches with the T/F machine 10, the MPU 26 reads the specific data and the control program from the memory unit 22 by the head 24 (STEP 312), and stores them in the RAM 32 (STEP 314).

The MPU 26 controls the sections 28 for proper trimming and forming actions with reference to the control program, the specific data, etc. (STEP 316). Namely, the MPU 26 controls the motors 16a and 16b for adjusting the rail width Aand C of the rails 12a and 12b. And the MPU 26 forwards the lead frames to a predetermined length in the direction of the arrow B (see Fig. 1) step by step with each trimming and forming action.

When one sequence of the trimming and forming actions are completed, the MPU 26 checks if no lead frames are left in the lead frame supplying magazines or not (STEP 318). In case of no lead frames, the MPU 26 stops the sections 28 of the T/F machine 10 (STEP 320) to complete the control. On the other hand, at the STEP 318, if there are the lead frames in the lead frame supplying magazines, the MPU 26 returns to the STEP 316 for the next sequence of actions.

In other embodiments, usually, the control program(s) stored in the T/F machine 10 must be changed when the die 18 or the die-punch set is exchanged. But the memory unit 22 of the third embodiment stores all the specific data and the control program for the die-punch set, so the T/F machine 10 need not have control programs of various types of die-punch sets. Namely, the T/F machine 10 can be controlled on the basis of the proper control program and the proper specific data. And changing control program(s) of the T/f machine 10 is not required.

## Claims

1. A machine (10) for trimming and forming lead frames, the machine (10) comprising an exchangeable die-punch set (18) adapted to a specific lead frame, characterised in that the die-punch set (18) includes means (22) for storing specific data for control and maintenance, and further characterised in that the machine comprises means (24) for reading the specific data from the storing means (22), and means (26) for controlling the trimming and forming operation and the maintenance of the machine (10) on the basis of a control programme and the specific data as read by the reading means (24).

2. A machine as claimed in claim 1 in which the specific data is identification data of the die-punch set (18), and in which the control means (26) selects the control programme on the basis of the identification data.

3. A machine as claimed in claim 1 or claim 2 in which the storing means (22) is capable of storing newly corrected data therein.

4. A machine as claimed in claim 3 in which the means (24) for reading the specific data from the storing means (22) also writes the newly corrected data to the storing means (22).

5. A machine as claimed in any one of claims 1 to 4 in which the means (22) for storing specific data for control and maintenance also stores a control programme.

6. A machine as claimed in claim 5 in which the reading means (24) also reads the control programme.

7. A machine as claimed in claim 5 or claim 6 in which the storing means is capable of storing a newly corrected programme and newly corrected specific data.

8. A machine as claimed in claim 7 together with claim 6 in which the reading means (24) also writes the newly corrected programme and newly corrected specific data.

## Patentansprüche

1. Maschine (10) zum Trimmen und Formen von Leiterrahmen, wobei die Maschine (10) einen austauschbaren Prägestanzsatz (18) umfaßt, der für einen spezifischen Leiterrahmen ausgebildet ist, dadurch gekennzeichnet. daß der Prägestanzsatz (18) Mittel (22) zum Speichern spezifischer Daten zur Steuerung und Wartung umfaßt, und weiters dadurch gekennzeichnet, daß die Maschine Mittel (24) zum Lesen der spezifischen Daten aus dem Speichermittel (22) und Mittel (26) zum Steuern des Trimm- und Formungsvorgangs und der Wartung der Maschine (10) auf Basis eines Steuerungsprogramms und der spezifischen Daten, die vom Lesemittel (24) gelesen werden, umfaßt.

2. Maschine nach Anspruch 1, bei der die spezifischen Daten Identifizierungsdaten des Prägestanzsatzes (18) sind und bei denen das Steuerungsmittel (26) das Steuerungsprogramm auf Basis der Identifizierungsdaten auswählt.

3. Maschine nach Anspruch 1 oder 2, bei der das Speichermittel (22) zum Speichern neu korrigierter Daten darin fähig ist.

4. Maschine nach Anspruch 3, bei der das Mittel (24) zum Lesen der spezifischen Daten aus dem Speichermittel (22) auch die neu korrigierten Daten in das Speichermittel (22) eingibt.

5. Maschine nach einem der Ansprüche 1 bis 4, bei der das Mittel (22) zum Speichern spezifischer Daten zur Speicherung und Wartung auch ein Steuerungsprogramm speichert.

6. Maschine nach Anspruch 5, bei der das Lesemittel (24) auch das Steuerungsprogramm liest.

7. Maschine nach Anspruch 5 oder 6, bei der das Speichermittel zum Speichern eines neu korrigierten Programms und neu korrigierter spezifischer Daten fähig ist.

8. Maschine nach Anspruch 7 gemeinsam mit Anspruch 6, bei der das Lesemittel (24) auch das neu korrigierte Programm und die neu korrigierten spezifischen Daten eingibt.

## Revendications

1. Machine (10) pour ajuster et former des cadres conducteurs, la machine (10) comprenant un groupe échangeable de matriçage-découpage (18) adapté à un cadre conducteur spécifique, caractérisée en ce que le groupe de matriçage-découpage (18) comprend un moyen (22) pour mémoriser des données spécifiques de contrôle et de maintenance et en outre caractérisée en ce que la machine comprend un moyen (24) pour lire les données spécifiques du moyen de mémorisation (22) et un moyen (26) pour commander l'opération d'ajustage et de formage et la maintenance de la machine (10) sur la base d'un programme de commande et des données spécifiques telles que lues par le moyen de lecture (24).

2. Machine comme revendiquée en revendication 1 dans laquelle les données spécifiques sont des données d'identification du groupe de matriçage-découpage (18) et dans laquelle le moyen de commande (26) sélectionne le programme de commande sur la base des données d'identification.

3. Machine comme revendiquée en revendication 1 ou revendication 2 dans laquelle le moyen de mémorisation (22) peut mémoriser des données nouvellement corrigées dans celle-ci.

4. Machine comme revendiquée en revendication 3 dans laquelle le moyen (24) pour lire les données spécifiques du moyen de mémorisation (22) écrit également les données nouvellement corrigées au moyen de mémorisation (22).

5. Machine comme revendiquée dans l'une quelconque des revendications 1 à 4 dans laquelle le moyen (22) pour mémoriser des données spécifiques de commande et de maintenance mémorise également un programme de commande.

6. Machine comme revendiquée en revendication 5 dans laquelle le moyen de lecture (24) lit également le programme de commande.

7. Machine comme revendiquée en revendication 5 ou revendication 6 dans laquelle le moyen de mémorisation peut mémoriser un programme nouvellement corrigé et des données spécifiques nouvellement corrigées.

8. Machine comme revendiquée en revendication 7 ensemble avec la revendication 6 dans laquelle le moyen de lecture (24) écrit également le programme nouvellement corrigé et les données spécifiques nouvellement corrigées.
